# EUROPEAN PATENT APPLICATION

(11) **EP 3 780 012 A1**
(43) Date of publication of application: **17.02.2021**
(21) Application number: 19770918.1
(22) Date of filing: 18.03.2019
(51) Int. Cl.: H01B 7/00, B23K 1/00, B23K 1/14, H01B 5/00, H01B 13/00, H01G 4/228, H02M 7/48

(54) **BUSBAR LAMINATE BODY, ELECTRONIC COMPONENT MOUNT MODULE PROVIDED WITH SAME, AND METHOD OF MANUFACTURING BUSBAR LAMINATE BODY**

(30) Priority: 23.03.2018 JP 2018055778; 30.01.2019 JP 2019013792
(71) Applicant: Nippon Chemi-Con Corporation, Tokyo 141-8605 (JP)
(72) Inventor: ICHIKURA, Osamu, Tokyo 141-8605 (JP); KUROSU, Mitsuru, Tokyo 141-8605 (JP); ABE, Tsubasa, Tokyo 141-8605 (JP); TAMAI, Yuya, Tokyo 141-8605 (JP); YAMAYA, Koji, Tokyo 141-8605 (JP); IDEUE, Takashi, Tokyo 141-8605 (JP)
(74) Representative: Baronetzky, Klaus
(86) International application number: PCT/JP2019/011155
(87) International publication number: WO 2019/181846

(57) **Abstract**

An object of the present invention is to provide an electronic component module or the like using a bus bar, which enables the use of flow solder by aligning the height of the solder mounting surface with the bus bar of the laminated anode and the bus bar of the cathode. A first bus bar layer stack comprising a first bus bar and a second busbar is insulated laminated, the first lead terminal opening of the electronic component is soldered on the outer surface side of the second bus bar is mounted on the outer surface side of the first bus bar is penetrated in a non-contact, and a second lead terminal insertion hole is soldered by inserting the first lead terminal at a position corresponding to the opening for the first lead terminal, the second lead terminal and the second lead terminal solder insertion hole at a position corresponding to the insertion hole for the second lead terminal is provided with a second lead terminal opening which is penetrated in a non-contact,The first lead terminal solder insertion hole and the second lead terminalsolderinsertion hole, Bus bar layer stack and Electronic component mounting module comprising the same, Method of manufacturing Bus bar layer stack Ver.1.1 on the outer surface side of the second bus bar, to the extent that it is possible to solder by flow solder, the bus bar layer stack is the same height.

## Description

### [Technical Field]

The present invention enables the use of flow solder by aligning the height of the solder mounting surface with the bus bar of the bus bar and the cathode of the laminated anode, an electronic component module or the like using the bus bar.

### [BACKGROUND ART]

Resistance is reduced by using a metal plate (bus bar) to the conductive material large current is applied in the module mounting a plurality of electronic components, it is known that it is possible to improve the heat dissipation while reducing the heat generation. In the case of using a large current, since the heat dissipation does not catch up is accumulated in the so-called printed wiring board or the like which is commonly used in the mounting of a small electronic device, the electronic component or the like is heat damage fear occurs.

Therefore, for example, when mounting a plurality of capacitors, the bus bar of the anode and the bus bar of the cathode through the insulating layer (e.g., a coating layer of an insulating sheet or an insulating material) laminated (bonded) by mounting a plurality side by side on one surface of the bonded bus bar, to improve the heat dissipation.

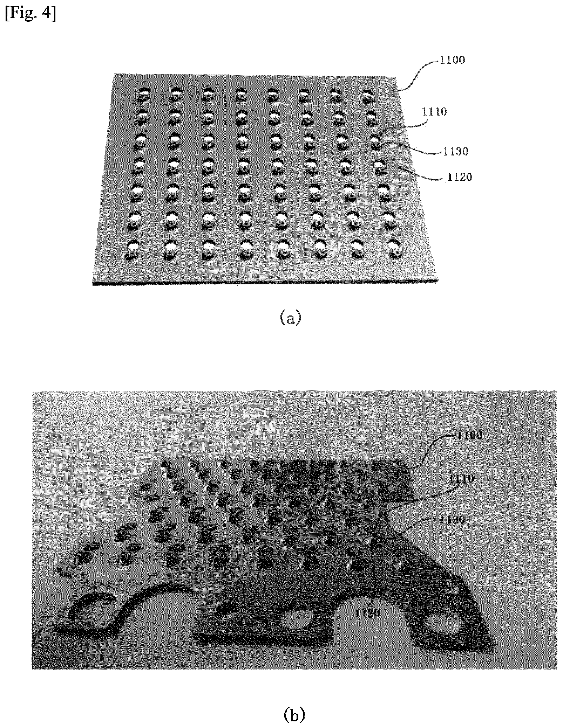

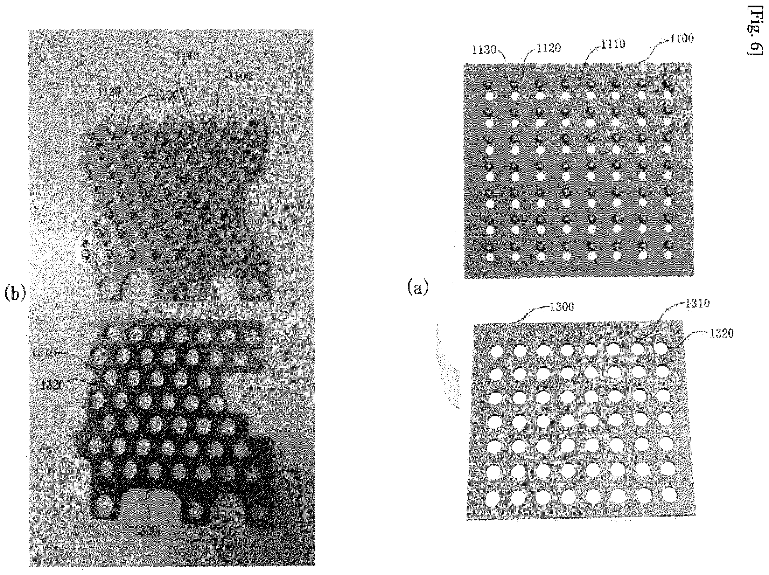

In FIG. 4 and the explanatory portion of the following Patent Document 1, "In the capacitor module 31 of the second embodiment shown in FIG. 4, the substrate 32 has a structure obtained by bonding the first and second metal plates 34 and 35 on both surfaces of the insulating sheet 33. In FIG. 6, the insulating sheet 33 is shown in a plan view. The insulating sheet 33 is made of a silicone resin and has a thickness of about 0.1 to 0.05mm. However, the insulating sheet 33 may be configured using other synthetic resins such as epoxy resin (resist)."

That is, in Patent Document 1, bonded while sandwiching the insulating sheet 33 between the first metal plate 34 and the second metal plate 35, the lead terminal 3a,3b of the multilayer capacitor 3 is perpendicularly penetrated erected to the metal plate, the structure in which the lead terminal 3a,3b is soldered to the metal plate 34 and 35 is disclosed.

As clearly shown in figure 4 of Patent Document 1, the lead terminal 3a is soldered to the bottom surface of the upper metal plate 34 with solder 16, the lead terminal 3b is soldered to the bottom surface of the lower metal plate 35 with solder 17. Therefore, in such a structure, just by the height corresponding to the thickness of the insulating sheet 33 and the lower metal plate 35, the height to be soldered of the pair of lead terminal 3a,3b are different from each other. Soldering operation in this case, although no problem occurs in the case of being soldered individually by hand, when considering the mass production process in expectation of some throughput using flow solder or the like can not cope with this.

### [Prior art documents]

### [Patent Document]

[Patent Document 1] JP-A-2001-178151

### [SUMMARY OF THE INVENTION]

### [Problem to be solved by the invention]

Conventionally, when mounting a plurality of lead-type electronic components to two bus bars stacked, the height of the mounting surface in the bus bar of the cathode and the bus bar of the anode (i.e., the height of the soldered point to each bus bar of the lead terminals of the anode and the cathode) is different, it is impossible to use the flow solder, there is a problem that the mounting work of the electronic component becomes complicated.

That is, when the soldered height of the pair of lead terminals becomes different from each other, although there is no problem if the soldering work by manual operation, if you try to utilize the flow soldering process which is often used in such mass production process, the soldering point height is different because it is difficult to perform the process. It cannot be simultaneously and uniformly immersed in a horizontal solder solution surface for soldered points of different heights. Each bus bar, since those having a certain thickness in consideration of heat dissipation or the like as long as the large current, the difference in height of the soldered point corresponding to the thickness for the flow soldering process is not negligible. Here, the flow solder, in a state of temporarily fixing the capacitor to the bus bar or the like, this is brought into contact with the solder bath to interpose solder between the terminals of the bus bar and the capacitor.

Therefore, each lead terminal of the electronic component module used by bonding the cathode bus bar and the anode bus bar, the structure that can be soldered to each bus bar by utilizing a flow solder having a higher mass production efficiency is required. The present invention has been made in view of the above problems, it was an object to provide an electronic component module to use the flow solder so that the height of the solder mounting surface with the bus bar of the cathode laminated, is same with the height of the solder mounting surface with the bus bar of the anode laminated.

### [Method for solving the problem]

Bus bar layer stack of the present invention, is comprising a first bus bar insulated laminated and a second bus bar insulated laminated,
the first bus bar included an opening for the first lead terminal of an electronic component that is mounted on the outer side of the first bus bar and soldered on the outer side of the second bus bar, through which the first lead terminal is penetrated in a non-contact manner, soldering insertion hole for the second lead terminal to be inserted and soldered to the second lead terminal of the electronic component,
the second bus bar included soldering insertion hole for the first lead terminal where the first lead terminal is inserted and soldered at a position corresponding to the opening for the first lead terminal, and an opening for the second lead terminal where the second lead terminal and the soldered insertion hole for the second lead terminal are penetrated in a non-contact manner at a position corresponding to the soldered insertion hole for the second lead terminal,
wherein the soldered insertion hole for the first lead terminal and the soldered insertion hole for the second lead terminal are at the same height on the outer side of the second bus bar to the extent that flow soldering can be used.

Further, preferably provided with a capacitor soldered on the outer surface side of the second bus bar is mounted on the outer surface side of the first bus bar, more preferably the bus bar layer stack side substantially lower half of the capacitor, and the bus bar layer stack including the soldered portion, the resin-molded capacitor mounting module.

Method of making the bus bar layer stack of the present invention is, a method for manufacturing a bus bar layer stack comprising a first bus bar and a second bus bar insulated and stacked, comprising,
the step of making an opening in the first bus bar for the first lead terminal of an electronic component that is mounted on the outer side of the first bus bar and soldered on the outer side of the second bus bar, which is penetrated by the first lead terminal in a non-contact manner and soldering insertion hole for the second lead terminal to be inserted and soldered to the second lead terminal of the electronic component,
the step of making soldering insertion hole for the first lead terminal in the second bus bar through which the first lead terminal is inserted and soldered at a position corresponding to the opening for the first lead terminal and an opening for the second lead terminal where the second lead terminal and the soldered insertion hole for the second lead terminal are penetrated in a non-contact manner at a position corresponding to the soldered insertion hole for the second lead terminal, and
the step of Insulated stacking of the first bus bar with the second bus bar,
wherein the soldered insertion hole for the first lead terminal and the soldered insertion hole for the second lead terminal are at the same height on the outer side of the second bus bar to the extent that flow soldering can be used.

### [Effect of the Invention]

Flow solder by aligning the height of the solder mounting surface by the bus bar of the laminated anode and the bus bar of the cathode, it is possible to provide an electronic component module or the like using the bus bar.

### [BRIEF DESCRIPTION OF THE DRAWINGS]

[Fig. 1] It is a diagram for explaining the overall configuration outline of the bus bar stack of the present embodiment, (a) shows the cross-sectional configuration outline of the bus bar stack, (b) is a diagram for explaining the cross-sectional configuration outline of the capacitor mounting module in a state of being temporarily mounted a capacitor.
[Fig. 2] It is a diagram for further explaining in detail a capacitor mounting module made of a bus bar stack capacitor is mounted, (a) is intended to explain a perspective view of a capacitor mounting module, (b) is intended to explain the bottom side before soldering the capacitor mounting module, (c) is a diagram for explaining in detail the cross-sectional configuration of the capacitor mounting module.
[Fig. 3] It is a diagram illustrating a typical example of a capacitor mounting module molded with a resin.
[Fig. 4] Is a diagram illustrating a typical example of a bus bar, a perspective view for explaining only the first bus bar from the convex body side.
[Fig. 5] Only the first bus bar is a diagram illustrating from the electronic component mounting side (the opposite surface side of the convex of convex body).
[Fig. 6] A first bus bar is a diagram illustrating a second bus bar used in a set in conjunction therewith.
[Fig. 7] It is a diagram illustrating a state in which the first bus bar and the second bus bar used in a set in conjunction therewith shown in FIG.6.
[Fig. 8] It is a diagram illustrating a state of arranging the insulating sheet on the convex body side of the first bus bar shown in FIG.4.
[Fig. 9] Between the slope of convex body and the inner peripheral wall of the second lead terminal opening of so that the short circuit due to solder adhesion does not occur (where indicated by (1) and (2) in FIG. 9 (a)), is a diagram illustrating a typical example of applying a resist (site indicated by a thick line), (a) shows a state in which a resist is applied, (b) is a diagram illustrating a state in which a resin is disposed after the resist coating.
[Fig. 10] (a) is an overall perspective view illustrating a configuration outline of a bus bar layer stack comprising a second bus bar previously subjected to improvement measures of flow soldering, (b) is a sectional view illustrating the internal configuration of the bus bar layer stack in a state of mounting the capacitor 11400, (c) is a sectional view illustrating the internal configuration of the bus bar layer stack in a state of eliminating the capacitor from (b).
[Fig. 11] (a) is a cross-sectional schematic view of a mounting module for explaining a state of fitting the soldered pallet of the present embodiment to the second bus bar as a preparation of the flow soldering process, (b) is a cross-sectional view for explaining the configuration of the soldered pallet, (c) is a perspective view for explaining the entire configuration of the soldered pallet.
[Fig. 12] (a) is a perspective view of a mounting module to be described by observing a state of fitting the soldered pallet of the present embodiment to the second bus bar as a preparation of the flow soldering process from the soldered pallet side, (b) is a diagram for explaining an enlarged part of the soldered pallet of the state shown in (a).

### [Forms for implementing the present invention]

Bus bar layer stack illustrated in the present embodiment, a plurality of electronic components such as a capacitor for example utilizing a large current, are mounted side by side in a planar shape by flow solder, can be utilized in a vehicle-mounted application or the like. Conventionally, the bus bar layer stack, since each of the upper layer side of the bus bar and the lower layer side of the bus bar has a considerable thickness, the soldered point of each bus bar lead terminal of the electronic component to be mounted is soldered, in the height direction difference of the degree corresponding to the thickness has occurred.

Since it is impossible to solder at the same time by utilizing the flow soldering process in the soldering point different height, a neck in the mass production process. In the present embodiment, it is possible to utilize the process of flow solder by aligning the height of the soldered point of each lead terminal to each bus bar, to propose a structure and configuration of the bus bar layer stack which is capable of solving the short-circuit problem due to solder bridge which is essential during flow solder utilization.

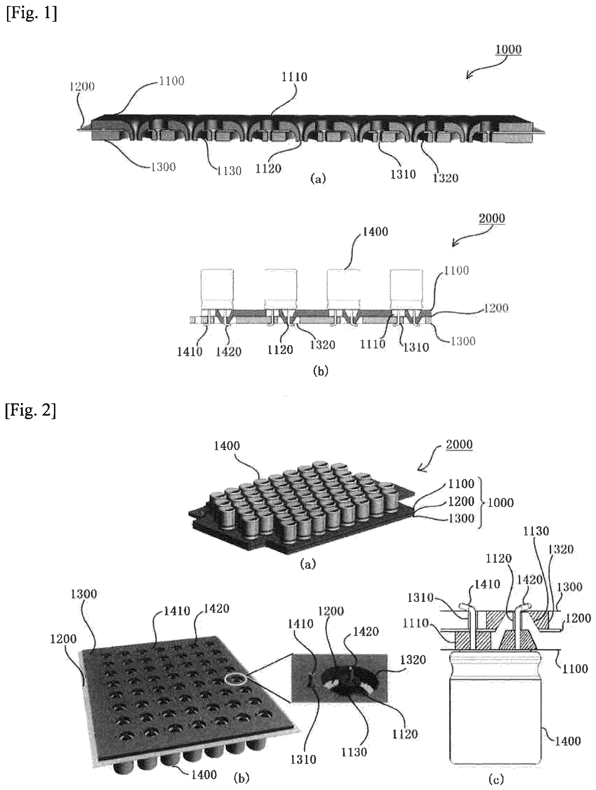

Figure 1 is a diagram illustrating an overall configuration outline of the bus bar stack 1000 of the present embodiment, FIG. 1 (a) shows a cross-sectional configuration outline of the bus bar stack 1000, FIG. 1 (b) is a cross-sectional configuration outline of the capacitor mounting module 2000 in a state where the capacitor 1400 is temporarily mounted it is a diagram for explaining.

In FIG. 1(a), the bus bar stack 1000 comprises a first bus bar 1100 described on the upper layer side, a second bus bar 1300 described on the lower layer side, and an insulating sheet 1200 disposed between the first bus bar 1100 and the second bus bar 1300. The first bus bar 1100 is substantially in the center of the convex body protruding on the second bus bar 1300 side, one of the lead terminals of the electronic component to be mounted is inserted and fixed, the second lead terminal soldered insertion hole 1120 comprising a.

The second bus bar 1300, the other lead terminal of the electronic component to be mounted is inserted and fixed, comprising a first lead terminal soldered insertion hole 1310. In the bus bar stack 1000 of FIG. 1 (a), will be the electronic component is mounted on the upper surface of the first bus bar 1100 on the upper surface side of the paper surface, the second bus bar 1300 on the lower surface side of the paper surface the lead terminal of the electronic component is to be fixed with solder by flow solder.

Each bus bar 1100 and 1300 is formed of a metal having a considerable thickness, it is possible to flow a large current with low resistance as well as excellent thermal conductivity. The smooth heat dissipation effect of the bus bar stack 1000, it is possible to prevent thermal damage to a plurality of electronic components mounted on the bus bar stack 1000.

As can be understood from FIG. 1, at a position corresponding to the first lead terminal solder insertion hole 1310 provided in the second bus bar 1300, the first lead terminal opening 1110 of a larger diameter is provided in the first bus bar 1100. The other lead terminal stretched from the electronic component mounted on the upper surface side of the first bus bar 1100, the first bus bar 1100 through by the first lead terminal opening 1110, the second by the first lead terminal solder insertion hole 1310 is electrically and mechanically soldered fixed to the bus bar 1300.

Similarly, at a position corresponding to the second lead terminal solder insertion hole 1120 provided with the first bus bar 1100, the second lead terminal opening 1320 of a larger diameter is provided on the second bus bar 1300. One lead terminal stretched from the electronic component mounted on the upper surface side of the first bus bar 1100, the second bus bar 1300 through by the second lead terminal opening 1320, the first by the solder insertion hole 1120 for the second lead terminal It is electrically and mechanically soldered fixed to the busbar 1100.

Here, the second lead terminal solder insertion hole 1120 of the first bus bar 1100 is provided on the convex body 1130 which is convex on the second bus bar 1300 side, and the convex body 1130 itself, the second by the second lead terminal opening 1320 without contacting the bus bar 1300, it is intended to be exposed to the bottom side of the second bus bar 1300.

With such a configuration, the bottom surface of the second lead terminal solder insertion hole 1120 of the first bus bar 1100 provided on the convex body 1130, the bottom surface of the first lead terminal solder insertion hole 1310 on the bottom side of the second bus bar 1300, it is possible to align the height of each other, also facilitates the use of flow solder. Incidentally, the insulating sheet 1200 may be formed by applying an insulating material such as various films (e.g., polyimide film) or a resist having insulating properties.

Further, in FIG. 1 (b), a state in which a plurality of capacitors 1400 as a typical example of the electronic component is temporarily mounted on the upper surface side of the first bus bar 1100, it shows a state before being soldered. As shown in FIG. 1 (b), the first lead terminal 1410 of the capacitor 1400, the first bus bar 1100 through the first lead terminal opening 1110 of the first bus bar 1100 in a non-contact, the first lead terminal solder insertion hole 1310 is inserted can be temporarily fixed bent at the bottom side of the second bus bar 1300. Thus, the first lead terminal 1410 is intended to be electrically connected only to the second bus bar 1300.

Further, as shown in FIG. 1 (b), the second lead terminal 1420 of the capacitor 1400, the second bus bar 1300 through the second lead terminal opening 1320 of the second bus bar 1300 in a non-contact, the second lead terminal solder insertion hole 1120 of the first bus bar 1100 is inserted it can be temporarily fixed bent at the bottom side of the first bus bar 1100. Thus, the second lead terminal 1420 is intended to be electrically connected only to the first bus bar 1100.

In other words, with respect to the second lead terminal 1420 as can be understood from FIG. 1 (b), where the first bus bar 1100 is flush recessed to the height position of the second bus bar 1300, i.e. the bottom surface of the convex body 1130, is intended to be fixed by soldering. To allow such a configuration, the second bus bar 1300, so as to allow the first recess of the bus bar (i.e., the convex body 1130) electrically non-contact, a second lead terminal opening 1320 including the convex body 1130 in a non-contact it is intended to include. Therefore, to be flow soldered, the first lead terminal 1410 exposed from the bottom surface of the second bus bar 1300, and the second lead terminal 1420 exposed from the bottom surface of the first bus bar 1100 is to be disposed at substantially the same height to the extent that flow solder is possible. When the flow solder, each polarity lead terminal and the bus bar may be the same height to the extent that sufficiently solder connected, specifically preferably within a height difference range of about 2mm, more preferably within a height difference range of about 1mm.

Figure 2 is a diagram of a capacitor mounting module 2000 made of a bus bar stack 1000 on which the capacitor 1400 is mounted, FIG.2 (a) is for explaining a perspective view of the capacitor mounting module 2000, FIG.2 (b) is for explaining the bottom side before soldering the capacitor mounting module 2000, FIG.2 (c) is a diagram for explaining in detail the cross-sectional configuration of the capacitor mounting module 2000.

As shown in FIG. 2 (a), the bus bar stack 1000 is capable of supplying a large current, and because it is also excellent in heat dissipation, even if mounted electronic components such as a large number of capacitors 1400 at a high density, the electronic component is thermally damaged it is avoidable. Especially capacitor 1400 is known to be vulnerable to high heat, it is possible to maintain the characteristics of high reliability and high durability in the bus bar stack 1000 of the present invention. Each bus bar 1100 and 1300 is constituted by a metal having a thickness of a certain degree in consideration of large current and heat dissipation, so that the strong characteristics of considerable strength can be obtained in strength. Therefore, it is possible to integrate without problem even a capacitor or the like whose life is greatly influenced by the heat.

Further, as shown in FIG. 2 (b), although each lead terminals 1410 and 1420 are exposed on the bottom side of the bus bar stack 1000, the exposed surface is available flow solder since it is substantially flat, it can be excellent in mass productivity. Further, although not shown in FIG. 2 (b), as shown in FIG. 2 (c), the lead terminals 1410 and 1420 can be temporarily fixed by bending a portion exposed from the bottom.

Here, as can be understood from FIG. 2 (b), the convex body 1130 of the first bus bar 1100, and the second lead terminal opening 1320 of the second bus bar 1300, a relatively close distance (e.g., about 5mm) will be located. Further, since the first bath bar 1100 and the second bath bar 1300 have different polarities from each other at either positive or negative polarity, it is preferable that a short circuit between them can be reliably prevented.

In particular, when using the flow solder, since the bottom side of the bus bar stack 1000 shown in FIG. 2 (b), i.e. the bottom side of the second bus bar 1300 is intended to be immersed in the solder tank, thereby, the convex body 1130 and the second lead terminal opening 1320 is solder short-circuited it is necessary to reliably avoid. Therefore, in the present embodiment, it is possible to apply a solder repellent resist agent (not shown) to the exposed portion of the bottom surface side of the second bus bar 1300.

Solder repelling resist agent, the entire bottom surface except the periphery of the first lead terminal solder insertion hole 1310 a bottom surface of the second bus bar 1300, and the inner peripheral wall surface of the second lead terminal opening 1320, it is preferable to place in. For the periphery of the first lead terminal solder insertion hole 1310, sufficient if the first lead terminal 1410 is provided enough space to maintain the electrical conduction is secured is soldered to the bottom surface of the second bus bar 1300, the other bottom surface portion it is possible to place all the resist.

Further, the inner peripheral wall of the second lead terminal opening 1320, in the second bus bar 1300, the convex body 1130 and the second lead terminal 1420 of the first bus bar 1100, since the closest site, it is preferable to place a resist agent. In addition, the resist agent may have any property of repelling this so as to prevent adhesion of flow solder, and may be preferably one having an insulating property, and an epoxy-based resist agent having excellent heat resistance may be used. Further, the resist agent may be disposed on the surface of the convex body 1130 of the first bus bar 1100 In addition, the resist agent may be subjected to a remove treatment with a laser, a chemical solution, or the like so as to leave only a desired portion after coating, spraying, or various deposition, or may be disposed only at the above desired portion by a masking screen or the like from the beginning. In addition, the resist agent may be previously attached at a stage before the bath bar is laminated.

Incidentally, as shown in FIG. 2 (b) enlarged view, between the first bus bar 1100 and the second bus bar 1300, in order to more reliably maintain the insulating properties in the second lead terminal opening 1320 at the time of flow solder, the opening area of the portion of the insulating sheet 1200 it can be smaller than the opening area of the second lead terminal opening 1320.

Further, from the opening of the location of the insulating sheet 1200 as only the convex body 1130 is exposed, the planar portion of the other first bus bar 1100 may be prevented from being exposed. Thus, even if the flow solder is moved to the first bus bar 1100 side along its inner peripheral wall is adhered to the second lead terminal opening 1320 excessively, the first bus bar 1100 is prevented by the insulating sheet 1200 it becomes impossible to contact the solder, so that it is possible to reliably and safely secure the insulating characteristics.

Further, as can be understood from FIG. 2 (c), the upper surface of the capacitor 1400 and the first bus bar 1100 (FIG. 2 (c) the lower surface of the paper surface (capacitor mounting surface)) is preferably mounted in a slightly floating state so as to have a very small distance. Capacitor 1400 may release gas by heat or over time due to use, and it is preferable to provide its emission path. Therefore, it is possible to provide a so-called rubber stage in the capacitor 1400. Note that the bottom surface to be soldered in FIG. 2 (c) is described above.

Further, as also shown in FIG. 2 (c), the bottom surface of the second bus bar 1300 (flow soldered surface), and the bottom surface of the convex body 1130, may not necessarily flush perfectly the same height, the flow solder it is sufficient that the height is uniform to the extent possible. In FIG. 2(c), a space is shown as a configuration in which a space is provided inside the convex body 1130, but said space may be filled with the constituent material of the first bus bar 110, and such a configuration is desirable in terms of low resistance and heat dissipation. Further, in FIG. 2 (c), although shown as a configuration in which a space is provided inside the convex body 1130, the space may be intended to be filled with a constituent material of the first bus bar 1100, such a configuration from the viewpoint of low resistance and heat dissipation it can be said to be preferable. In particular, it is preferable to actively fill the space shown by hatching in FIG. 2 (c). Spatial site shown by hatching in FIG. 2 (c), since the concave portion of the rear surface side of the convex opening and the convex body 1130 respectively formed in the first bus bar 1100 and the second bus bar 1300, the space is filled with a resin it is preferable to improve the thermal conductivity. Above all, for the concave portion of the rear surface side of the convex convex body 1130 adjacent to the first lead terminal opening 1110 which is the space of the capacitor 1400 (just above the paper surface of the capacitor 1400 in FIG. 2 (c)), by positively filling the resin, the capacitor 1400 is more stably fixed preferable because that become.

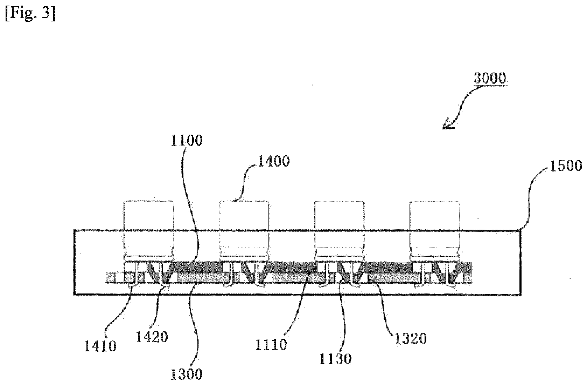

Figure 3 is a diagram illustrating a typical example of a capacitor mounting module 3000 molded with a resin 1500. In FIG. 3 shows a state of molding a bus bar stack comprising a first bus bar 1100 and a portion of the second bus bar 1300 and the capacitor 1400 (typically substantially lower half) and the lead terminals 1410 and 1420 with a resin 1500. Although not explicitly shown in FIG. 3, the lead terminals 1410 and 1420 are those already soldered.

As shown in FIG. 3, if molded with a resin 1500, the resin 1500, and the surrounding space of the convex body 1130, since it is filled also enters the first lead terminal opening 1110, not only the heat dissipation characteristics is improved, the overall strength is also increased greatly, the vibration resistance and durability is improved. Further, since the capacitor 1400 is molded with each bus bar 1100 and 1300, so that the capacitor 1400 is fixed even resin 1500, also improved large impact resistance.

In particular, as apparent from FIG. 3, by utilizing a bus bar whose surface area is increased becomes uneven shape rather than merely planar bus bar, since it is possible to secure a large contact area with the resin 1500, the heat dissipation characteristics and adhesive strength can be increased by this. Even when a large vibration, impact, and acceleration are applied, since the entire resin 1500 holds the shape, as compared with the case of fixing only with the lead terminals 1410 and 1420, the load on the lead terminals 1410 and 1420 can be reduced. Although not shown in FIG. 3, further arbitrary shape to the bus bars 1100 and 1300, it may be intended to further increase the contact area between the resin 1500 provided with irregularities of arbitrary size. Although not shown, the resin 1500 may be provided with any path hole for degassing of the capacitor 1400.

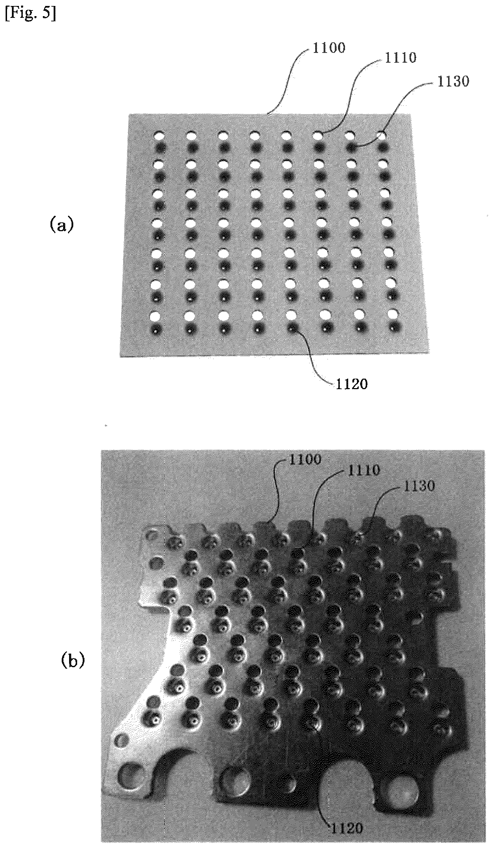

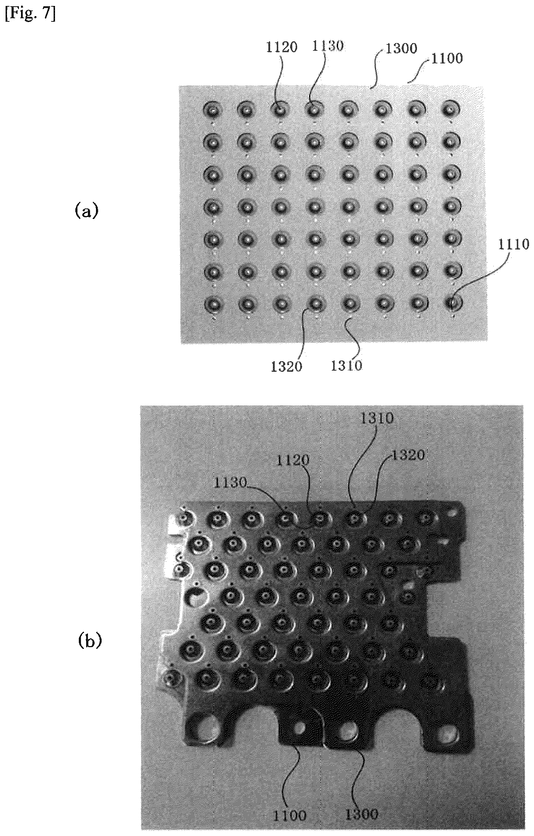

FIG. 4 to 8 are views illustrating a typical example of a bus bar, FIG. 4 is a perspective view illustrating only the first bus bar 1100 from the convex side of the convex body 1130. Further, FIG. 5 is a diagram illustrating only the first bus bar 1100 from the electronic component mounting side (the convex opposite surface side of the convex body 1130). Further, FIG. 6 is a diagram illustrating a first bus bar 1100 and a second bus bar 1300 used in a set in combination therewith, FIG. 7 is a diagram illustrating a state in which the first bus bar 1100 and the second bus bar 1300 shown in FIG. 6 are laminated set.

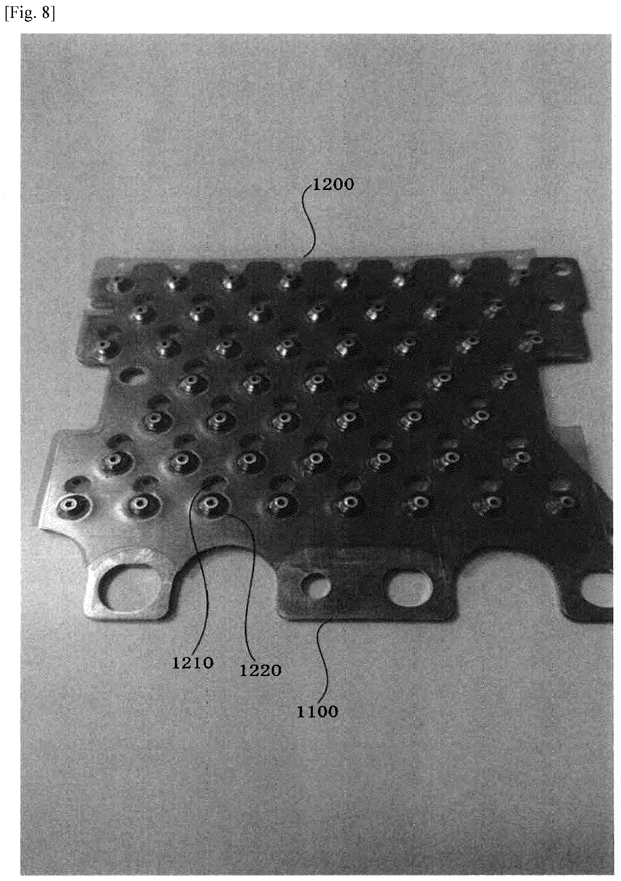

Further, FIG. 8 is a diagram illustrating a state in which the insulating sheet 1200 is disposed on the convex body 1130 side of the first bus bar 1100 shown in FIG.4. As can be understood from FIG. 8, the insulating sheet 1200 is provided with holes 1210 and 1220 to each lead terminal 1410 and 1420 is inserted. In particular, the lead terminal 1420 in a state of being inserted into the convex body 1130, since the convex body 1130 is intended to insert the insulating sheet 1200, the hole 1220 becomes larger than the hole 1210, the hole diameter of the hole 1220 is large enough so that the convex body 1130 can be inserted. On the other hand, the hole diameter of the hole 1220, in order to ensure good insulation with the second bus bar 1300, it is preferable that the smaller than the second lead terminal opening 1320 of the second bus bar 1300.

Thus, the insulating sheet 1200, since forming a flange portion protruding as an umbrella in the second lead terminal opening 1320, the first bus bar 1100 is exposed except the convex body 113 in the second lead terminal opening 1320 without being, the first bus bar 1100 in the second lead terminal opening 1320 in a plan view of FIG. 8 (observation from the solder dip side) is intended to be shielded. If, even if a phenomenon that solder at the edge of the second lead terminal opening 1320 is transmitted to the first bus bar 1100 side occurs, so that the solder is blocked by the flange portion protruding the insulating sheet 1200.

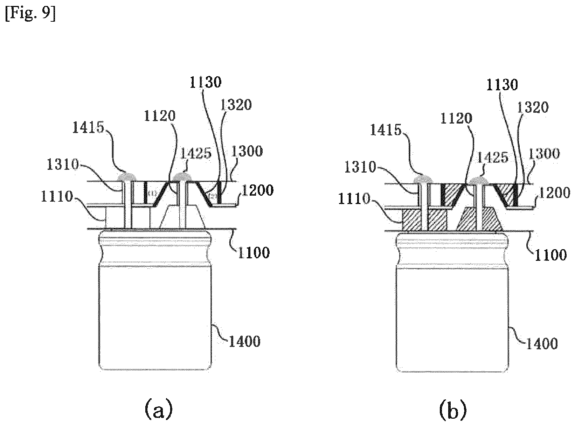

FIG.9, between the inner peripheral wall of the slope and the second lead terminal opening 1320 of the convex body 1130 (FIG. 9 (a) as short circuit due to solder adhesion (where indicated by (1) and (2)) does not occur in, a diagram illustrating a typical example of applying a resist (thick line), FIG. 9 (a) shows a state in which a resist is applied, FIG. 9 (b) is a diagram illustrating a state in which the resin is disposed after the resist coating. In FIG. 9, 1415 and 1425 show solder, respectively.

As shown in FIG. 9 (a), it is possible to avoid the adhesion of the solder because the resist is repelled at the coating site by applying a resist at the site shown by the thick line of (1) and (2) in FIG. Thus, a short circuit due to solder between the first bus bar 1100 and the second bus bar 1300 can be prevented. In FIG. 9 (a), shown in (1) and (2), preferably the solder bridge by arranging the resist on either the inner peripheral wall indicated by the thick line of the slope tapered portion or the second lead terminal opening 1320 indicated by the thick line of the convex body 1130 can be prevented. More preferably, solder bridging by applying a resist to both the inner peripheral wall indicated by the thick line of the slope tapered portion and the second lead terminal opening 1320 indicated by the thick line of the convex body 1130 can be prevented.

Further, it is preferable that the recessed portion shown by hatching in FIG. 9 (b) is positively filled with resin. By filling the resin, it is possible to improve the reliability and life of the capacitor 1400 heat dissipation is promoted. In FIG. 9, the description thereof is omitted with the same reference numerals in the corresponding portions and FIG. 2 (c).

(For improvement of the flow soldering in the first lead terminal solder insertion hole) by convex around the first lead terminal solder insertion hole 1310 on the outer surface side (solder tank dip side), the contact surface area between the molten solder is increased heat is easily taken around the first lead terminal solder insertion hole 1310 of the second bus bar 1300, it is possible to further good soldering solder wettability is improved.

Further, for example, when the second bus bar 1300 by drawing from the inner surface side (opposite side of the solder tank dip) to the outer surface side to the outer surface side is convex to the outer surface side, the inner surface side becomes concave so that the portion becomes thin heat capacity is reduced, it is possible to increase the temperature around the first lead terminal solder insertion hole 1310 of the rapid heat uptake and the second bus bar 1300. Thus, it becomes possible to perform soldering further good by improving the creep-up of the wettability and solder of the solder.

Furthermore, if before the flow solder, by applying a resist to the second bus bar 1300, when it is necessary to strip the resist of the soldered portion, the periphery of the first lead terminal solder insertion hole 1310 by a convex shape, there is also an advantage that the resist peeling by a milling machine or the like can be easily performed.

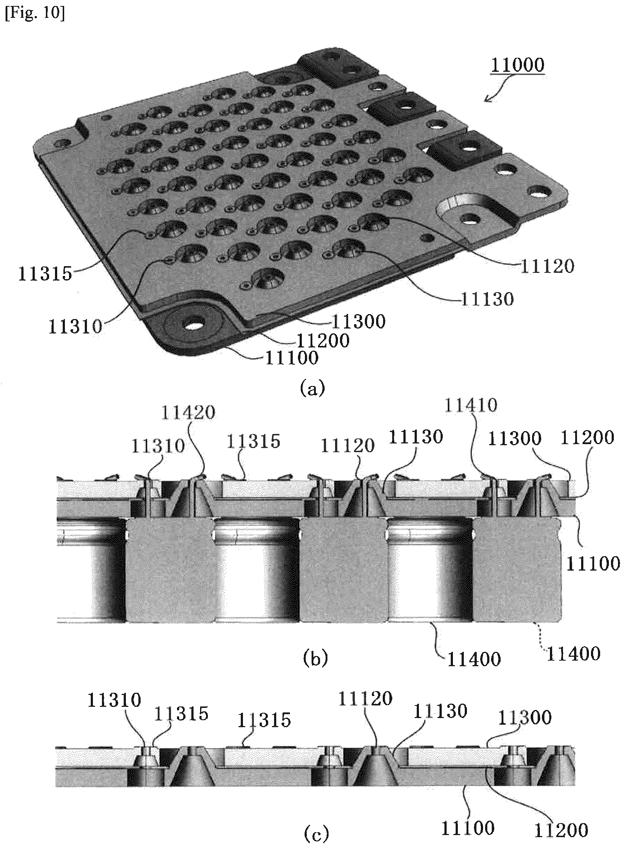

FIG.10 (a) is an overall perspective view illustrating an outline of the configuration of the bus bar stack 11000 comprising a second bus bar 11300 which is previously subjected to improvement measures for flow soldering, FIG. 10 (b) is a sectional view illustrating the internal configuration of the bus bar stack 11000 in a state of mounting the capacitor 11400, FIG. 10 (c) is a sectional view illustrating the internal configuration of the bus bar stack 11000 in a state of eliminating the capacitor 11400 from (b).

As shown in FIG. 10, the second bus bar 11300, pre-insulating sheet 1200 and the first bus bar 11100 is exposed surface side from the side to be laminated (outer surface side) the first lead terminal solder insertion hole 11310 is formed by ϕ1.0 press withdrawal or the like toward.

Thus, since the periphery of the first lead terminal solder insertion hole 11310 is formed on the convex body 11315 on the outer surface side (the upper surface side in FIG. 10 (a)), the contact area between the molten solder during flow soldering increases the temperature of the second bus bar 11300 more quickly becomes to increase, soldering can be easily and well performed. The height of the convex body 11315 is preferably about 1 to 2mm, for example. Incidentally, the second lead terminal solder insertion hole 11120 is provided in the top center of the convex body 11130 as shown in FIG. 10.

That is, in the present embodiment, the first bus bar 11100 is provided with a convex body 11130, and the second bus bar 11300 is provided with a convex body 11315, any of the convex bodies 11130, 11315 is also those formed convex on the solder dip side during flow soldering. 10 (b), as specified in (c), in the case of performing drawing, since the inner surface side of the first lead terminal solder insertion hole 11310 is reduced heat capacity of the portion becomes concave thin, the flow solder temperature is preferably increased rapidly during soldering.

Further, the first lead terminal 11410 and the second lead terminal 11420 of the capacitor 11400, each first lead terminal solder insertion hole 11310 (convex body 11315) and the second lead terminal solder insertion hole 11120 (convex body 11130) is derived from the outer surface side is soldered, the configuration is not described in detail here because it is a technical matter already described as described above. Incidentally, the extent of spreading in the height and the plane direction of the convex body 11315 around the first lead terminal solder insertion hole 11310 (size) can be any one, the flow solder to the extent that can be satisfactorily performed (heat is rapidly transferred) since it is sufficient as long as the size or the like, it is not necessary to excessively large and high.

### (Flow solder using a soldered pallet (mask) in place of the resist)

If, by utilizing the mounting module in a state where the resist agent remains in the bus bar layer stack or the like even after the electronic component is mounted by flow solder, due to the residual resist for example deterioration of the thermal conductivity lowering or the like of the cooling function due can not be said to be feared. Of course, even if the improvement measures of the cooling function by the heat sink or the like is implemented, it is undeniable that the heat is likely to cage in the module by the resist agent occurs. On the other hand, the peel removal operation of the resist agent requires a suitable process, labor and time.

Therefore, it is known to use a soldered pallet for masking from solder instead of the use of a resist agent. The soldered pallet is soldered by flow solder electronic components after mounting laminated to the bus bar layer stack. Soldered pallet conventionally utilized is provided with an opening, which is of a flat planar shape. That is, it has been utilized as a soldered pallet a thin metal plate which is patterned in advance so as to mask the portion not to be soldered in the process of the flow solder with the solder pallet.

In the case of soldering by flow solder to a conventional circuit board or the like conventionally known well, functionally sufficiently by masking with a solder pallet thin metal plate of a flat plate It has been taken to be sufficient. However, when the flow soldering is mounted by laminating a flat planar shape soldered pallet to the bus bar layer stack with two or more bus bars are laminated as in the present invention, the thickness and its heat capacity of each bus bar is relatively large since, in particular temperature rise relative to the bus bar located farther from the solder bath becomes insufficient, the resulting reduction in solder wettability is a concern.

That is, the heat of the solder bath is not sufficiently transferred to the bus bar farther from the solder bath, therefore, a situation where soldering is performed in a state where the temperature is not sufficiently increased is feared, such as quality and manufacturing defects soldering defects from poor solder wettability and solder creep in such a case occurs frequently It is feared that a cause. Therefore, in the present embodiment, it is assumed to form a soldered pallet three-dimensionally, by increasing the contact surface between the solder by providing a protruding piece in the bus bar direction, thereby to remove and reduce the above concerns such as solder wettability.

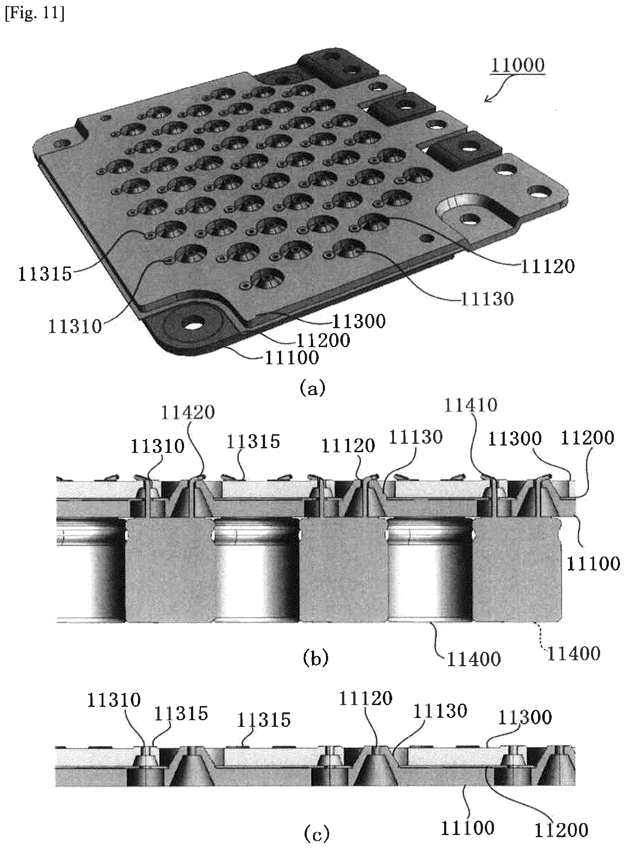

Therefore, the following will be described in more detail with reference to the drawings. 11 (a) is a cross-sectional schematic view of a mounting module for explaining a state of fitting the soldered pallet 1600 of the present embodiment to the second bus bar 11300 as a preparation of the flow soldering process, FIG. 11 (b) is a cross-sectional view illustrating the configuration of the soldered pallet 1600, FIG. 11 (c) is a perspective view for explaining the entire configuration of the soldered pallet 1600.

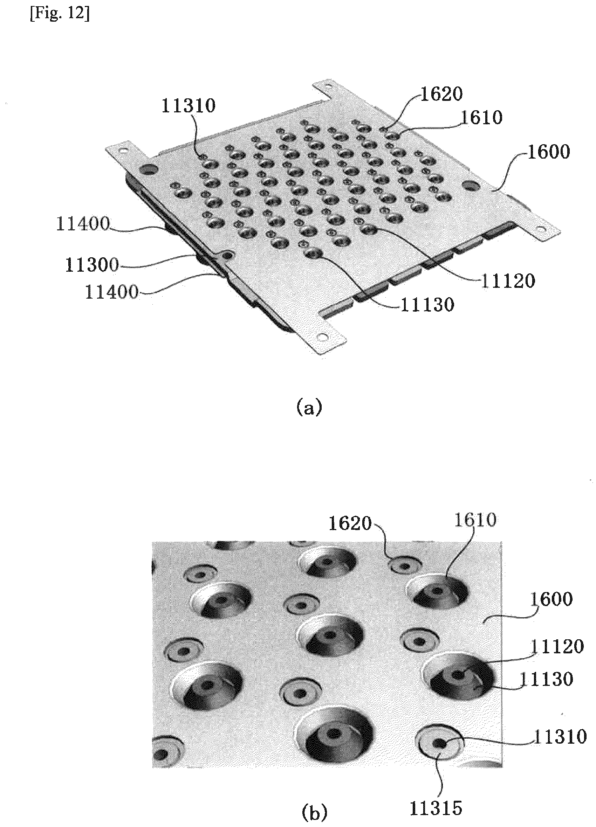

Further, FIG. 12 (a) is a perspective view of a mounting module to be described by observing a state of fitting the soldered pallet 1600 of the present embodiment to the second bus bar 11300 as a preparation of the flow soldering process from the soldered pallet 1600 side, FIG. 12 (b) is a diagram for explaining an enlarged portion of the soldered pallet 1600 in the state shown in FIG. 12 (a).

As shown in FIGS. 11 and 12, the protruding piece 1610 and the opening hole 1620 is provided in the soldered pallet 1600 typically formed of a metal such as titanium. Projecting piece 1610, in the second lead terminal opening 11320 of the second bus bar 11300, with respect to the vicinity of the center of the slope tapered portion of the convex body 11130 of the first bus bar 11200, the tip abuts the slope or molten solder does not exude spaced, are arranged to fit each other. Further, by providing a distance to the extent that the molten solder does not exude, absorption of the tolerance variation of the product by manufacturing (the pallet opening with solder is caught in the convex body, the solder pallet from the bus bar layer stack is prevented from floating) and advantages such as can be avoided scratches on the bus bar layer stack can be expected.

With this configuration, the molten solder becomes possible to penetrate into the second lead terminal opening 11320, the molten solder is attached to the vicinity of the center of the slope tapered portion of the convex body 11130 to heat the second lead terminal solder insertion hole 11120 near. Therefore, the soldering of the second lead terminal 11420 can be performed more smoothly. Further, the molten solder, since the degree of penetration into the second lead terminal opening 11320 by the protruding piece 1610 is limited, it does not exude beyond the protruding piece 1610. Therefore, there is no concern such as excessive weight increase due to short-circuit bridging or adhesion solder between both poles of the bus bar in the second lead terminal opening 11320 by solder.

Further, as shown in FIG. 10, the convex body 11130 may be formed so as to protrude from the inside of the second lead terminal opening 11320 on the outer surface side of the bus bar (e.g., about 1 to 2mm). At this time, the convex body 11130 and the convex body 11315, when the flow solder, each polarity lead terminal and the bus bar may be the same height to the extent that is sufficiently solder connected, specifically preferably within a height difference range of about 2mm, more preferably within a height difference range of about 1mm. Thus, the contact surface area between the molten solder of the convex body 11130 and the solder tank is increased, it is possible to more effectively heat the vicinity of the second lead terminal solder insertion hole 11120.

The opening hole 1620, so that it is possible to solder the first lead terminal 11410 to the second bus bar 11300 in the first lead terminal solder insertion hole 11310, is provided at a corresponding position. Although not shown, the convex body 11315 around the first lead terminal solder insertion hole 11310 may be formed so as to protrude from the inside of the opening hole 1620. Thus, the contact surface area between the molten solder of the convex body 11315 and the solder tank is increased, it is possible to more effectively heat the vicinity of the first lead terminal solder insertion hole 11310.

Further, alignment of the soldered pallet arrangement is also facilitated. Furthermore, the diameter of the root rising portion of the protruding piece 1610, it is preferable to match the opening diameter of the second lead terminal opening 11320 of the second bus bar 11300, from the viewpoint of improving the fitting of the soldered pallet 1600 and the second bus bar 11300. That is, preferably, in the soldered pallet 1600 mounting state, the protruding piece 1610 is assumed to be elongated and formed toward the vicinity of the center of the slope tapered portion of the convex body 11130 from the circumferential edge portion of the second lead terminal opening 11320.

Bus bar stack and the capacitor mounting module of the present invention is not limited to the configuration and method described in the above embodiments, suitably within the scope and within the technical concept of the present invention within the obvious to those skilled in the art changing its configuration, combined applied, and it is possible to change the method.

### [Industrial Applicability]

The present invention is suitable for mounting modules of a plurality of electronic components exemplifying a capacitor.

### [Description of sign]

- 1000: bus bar layer stack,
- 1100: first bus bar,
- 1110: opening for the first lead terminal,
- 1120: soldered insertion hole for the second lead terminal,
- 1130: convex body,
- 1200: insulating sheet,
- 1300: second bus bar,
- 1310: first lead terminal soldered insertion hole,
- 1320: opening for the second lead terminal,
- 1400: capacitor,
- 1410: first lead terminal,
- 1420: second lead terminal.

## Claims

1. A bus bar layer stack **characterized in that** the bus bar layer stack is comprising an insulating laminated first bus bar and a second bus bar,
the first bus bar includes first lead terminal openingfirst lead terminalof the electronic component to be soldered on the outer surface side of the second bus bar is mounted on the outer surface side of the first bus bar is penetrated in a non-contact,the second lead terminal of the electronic component is inserted and soldered second lead terminal insertion hole,
the second bus bar includes a first lead terminal solder insertion hole the first lead terminal is inserted into the position corresponding to the opening for the first lead terminal is soldered,the second lead terminal and the second lead terminal solder insertion hole at a position corresponding to the solder insertion hole for the lead terminal is provided with a second lead terminal opening which is penetrated in a non-contact, wherein the first lead terminal solder insertion hole and the second lead terminal solder insertion hole,on the outer surface side of the second bus bar,to the extent that it is possible to solder by flow solder,the same height

2. Bus bar layer stack and Electronic component mounting module comprising the same,Method of manufacturing Bus bar layer stack Ver.1.1
The busbar layer stack accordingto claim 1,
wherein the soldered insertion hole for the second lead terminal,
the first bus bar is formed in a protruding convex body on the second bus bar side,the convex body of the first bus bar is disposed in the second lead terminal opening of the second bus bar.

3. The bus bar layer stack according to claim 2,
wherein a convex body of the first bus bar,and the second lead terminal opening located around the convex body,so as not to occur a short circuit by solder between,
a resist for preventing solder adhesion is provided on the outer peripheral wall surface of the convex body of the first bus bar and/or the inner peripheral wall surface of the opening for the second lead terminal.

4. The bus bar layer stack according to claim 3,is **characterized in that**,
the resist is further disposed on the outer surface side of the second bus bar except the first lead terminal solder insertion hole and the inner peripheral wall surface of the second lead terminal opening.

5. The bus bar layer stack according to any one of claims 1 to 4,**characterized in that** the insulating sheet disposed between the first bus bar and the second bus bar,
a hole through which the convex body of the first bus bar penetrates,and a hole through which the first lead terminal smaller than the hole through which the convex body penetrates,as a set,corresponding to the electronic components individually comprising.

6. The bus bar layer stack according to any one of claims 1 to 5,**characterized in that**
the soldered insertion hole for the first lead terminal of the second bus bar is convex on the outer surface side.

7. Electronic component mounting module,**characterized in that**,
a bus bar layer stack according to any one of claims 1 to 6, and an electronic component whose lead terminal is soldered on the outer surface side of the second bus bar is mounted on the outer surface side of the first bus bar,

8. The electronic component mounting module according to claim 7, Bus bar layer stack and Electronic component mounting module comprising the same, Method of manufacturing Bus bar layer stack Ver.1.1 the electronic component is a capacitor,the bus bar layer stack side substantially lower half of the capacitor,and the bus bar layer stack including the soldered portion,the resin molded.

9. Method of manufacturing a bus bar layer stack,**characterized in that** the manufacturing method of the bus bar layer stack comprising an insulating laminated first bus bar and a second busbar,the method comprising,
the step of that the first bus bar,the first lead terminal opening first lead terminal of the electronic component to be soldered on the outer surface side of the second busbar is mounted on the outer surface side of the first bus bar is penetrated in a non-contact,the second lead terminal of the electronic component is inserted a soldered second lead terminal insertion hole, the step of that the second bus bar,the first lead terminal at a position corresponding to the opening for the first lead terminal is inserted soldered first lead terminal insertion hole, the second lead terminal and the second lead terminal solder insertion hole at a position corresponding to the solder insertion hole for the second lead terminal a second lead terminal opening is penetrated in a non-contact,after performing the step of forming,
and the step of insulating and laminating the first bus bar and the second bus bar,
wherein the solder insertion hole for the first lead terminal and the solder insertion hole for the second lead terminal,on the outer surface side of the second bus bar,to the extent that it is possible to solder by flow solder,the same height.

10. Method of manufacturing an electronic component mounting module according to the claim 9,**characterized in that** further comprising the step of soldering the electronic component to the bus bar layer stack production.

11. Method of manufacturing an electronic component mounting module according to claim 10,**characterized in that** the bus bar layer stack,the solder repel solder pallet having an opening in which the portion for soldering the lead terminals of the electronic component is opened,the electronic component after the step of laminating and mounting the solder by flow soldering.

12. Method of manufacturing the electronic component mounting module according to claim 11, Bus bar layer stack and Electronic component mounting module comprising the same, Method of manufacturing Bus bar layer stack Ver.1.1 the soldered insertion hole for the second lead terminal, the first bus bar protrudes on the second bus bar side, so as to be disposed in the second lead terminal opening of the second bus bar is formed in a convex body,
the soldered pallet is provided with a protruding piece protruding in the bus bar stack direction from the opening which is opened,
if mounted stacked on the bus bar stack, the protruding piece is disposed in the opening for the second lead terminal.

13. Method of manufacturing an electronic component mounting module according to claim 12, the tip of the protruding piece is fitted to the convex body near the center of the height of the convex body.

14. Method of manufacturing the electronic component mounting module according to claim 13, the tip of the protruding piece and the convex body are fitted at intervals such that the molten solder does not exude.

15. An Electronic component mounting module, **characterized in that**.
a bus bar layer stack according to claim 2,
and an electronic component whichis soldered mounted on the bus bar layer stack,
Solder is attached to the vicinity of the top half of the convex body.
